# FASCICULE DE BREVET EUROPEEN

(11) **EP 2 542 042 B1**
(45) Date de publication et mention de la délivrance du brevet: **26.02.2014**
(21) Numéro de dépôt: 12173346.3
(22) Date de dépôt: 25.06.2012
(51) Int. Cl.: H05K 7/14

(54) **Dispositif de verrouillage de cartes électroniques dans des équipemements embarqués**
Verriegelungsvorrichtung für elektronische Karten in aeronautischen Ausstattungen
Device for locking electronic cards in avionics equipments

(30) Priorité: 29.06.2011 FR 1155836
(43) Date de publication de la demande: 02.01.2013
(73) Titulaire: Airbus Operations S.A.S., 31060 Toulouse (FR)
(72) Inventeur: Engelvin, Pierre-Louis, 31130 BALMA (FR); Lafont, Patrice, 31280 MONS (FR)
(74) Mandataire: Gicquel, Olivier Yves Gérard

(56) Documents cités:
- EP-A1- 0 613 336
- US-B1- 6 317 967

## Description

La présente invention a pour objet un dispositif de verrouillage / déverrouillage de cartes électroniques dans des équipements embarqués.

### Préambule et art antérieur

Dans de nombreux domaines, notamment l'aéronautique, on utilise des équipements électroniques embarqués sous forme de bacs à cartes, connus en soi.

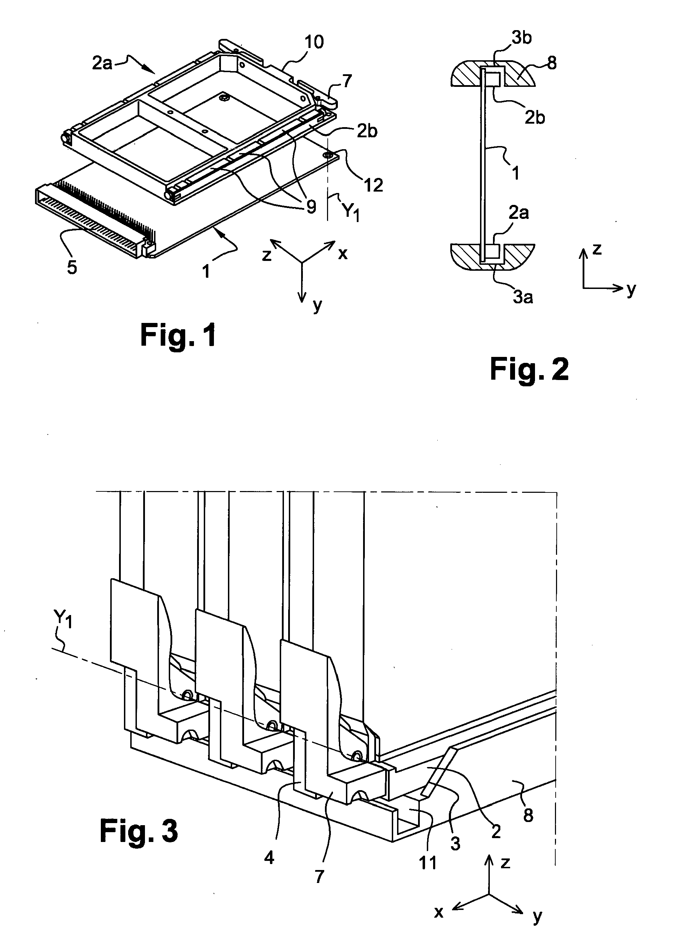

Pour former un équipement complet, par exemple un calculateur, des cartes électroniques 1 sont montées dans un cabinet électronique, configuré sous forme de boitier parallélépipédique, en suivant deux **supports glissières,** supérieur 3b et inférieur 3a, ménagés dans le châssis du cabinet électronique (voir figure 2). Ces cartes électroniques, disposées parallèlement les unes aux autres, viennent s'enficher sur des connecteurs disposés sur une carte dite fond de panier, qui assure l'interconnexion entre les cartes électroniques et divers câblages reliés à d'autres systèmes.

Chaque carte électronique 1 est usuellement dotée d'un levier d'extraction, qui permet d'appliquer un effort de traction sur la carte de manière à déconnecter son connecteur 5 de la carte fond de panier (non illustrée sur les figures).

Dans le but d'éviter une déconnexion intempestive d'une carte électronique sous l'effet des mouvements ou vibrations du véhicule dans lequel ces cartes sont embarquées, ces cartes électroniques 1 sont généralement équipées de **glissières de verrouillage** 2 sur deux de leurs bords, comme le montre la figure 1.

Les glissières de verrouillage 2a, 2b, assemblées sur un bâti 10 sensiblement rectangulaire, solidarisé à la carte électronique 1 par des moyens connus, assurent des fonctions : mécanique (notamment de tenue aux contraintes vibratoires), électrique (de continuité électrique de chaque carte électronique 1 avec le châssis 8 du calculateur) et thermique (de conduction thermique entre la carte électronique et le châssis 8 du calculateur).

Ce type de glissière de verrouillage 2a, 2b, présenté, par exemple, dans le brevet US 1.217.539 (Underwood 1915) ou US 4.354.770, est constitué d'une succession de mors 9 pourvus de plans inclinés traversés par un élément de serrage. Lors du serrage de cet élément de serrage, par exemple par l'action d'un levier de verrouillage 7 solidaire du bâti de glissières 10, les plans inclinés des mors 9 engendrent un élargissement de la glissière de verrouillage 2a, 2b. Il en résulte un coincement par friction de la carte électronique 1 dans le support glissière 3a, 3b correspondant. A l'inverse, le desserrage de l'élément de serrage relâche l'effort entre les mors 9 et provoque le rétrécissement de la glissière de verrouillage 2a, 2b dans le support glissière 3a, 3b correspondant, et donc la libération de la carte électronique 1.

Il est souhaitable d'éviter de tenter d'extraire la carte électronique 1 de son logement lorsqu'elle est encore verrouillée par les glissières de verrouillage 2a, 2b, pour éviter de l'endommager.

La demande de brevet Européen publiée sous le numéro EP 0 613 336 (Société IBM) décrit quant à elle un dispositif réalisant à la fois les fonctions de raidisseur de carte électronique et de dispositif d'insertion et d'extraction de carte. Le dispositif décrit comporte des glissières simples, non pourvues de système de verrouillage, ainsi que des éléments capables de coulisser latéralement le long du bord supérieur du dispositif de façon à venir bloquer le mouvement des leviers d'extraction dont le dispositif est pourvu. Le dispositif ne comportant pas de leviers de verrouillage capable d'agir sur les lissières pour assurer le blocage de la carte dans le bac à cartes destiné à la loger, les éléments de blocage jouent ici le rôle de verrous empêchant une extraction intempestive de la carte.

### Exposé de l'invention

L'invention vise à cet effet un dispositif de verrouillage / déverrouillage de carte électronique, ladite carte étant du type adaptée à être insérée dans un cabinet électronique, en suivant au moins un support glissière, ménagé dans le châssis dudit cabinet électronique,
le dispositif comprenant:
- un bâti sensiblement rectangulaire, adapté à être solidarisé à la carte électronique, le bâti supportant au moins une glissière de verrouillage, adaptée à verrouiller la carte électronique sur le support glissière, par l'action d'un organe de verrouillage, mobile entre une position dite de repos et une position dite de verrouillage,
   un repère direct étant défini par rapport à ce bâti, ledit repère comportant un axe longitudinal X parallèle à la direction d'insertion du bâti dans le cabinet électronique, un axe vertical Z perpendiculaire au précédent et situé dans un plan parallèle au plan moyen du bâti, et un axe latéral Y perpendiculaire aux axes précédents,
- un levier d'extraction, mobile en rotation, entre une position de repos et une position de verrouillage, autour d'un axe Y1, parallèle à l'axe Y, ledit levier d'extraction étant adapté à permettre l'application d'un effort selon l'axe longitudinal X entre le bâti et le châssis,
   l'organe de verrouillage comportant une extension adaptée à venir se placer selon l'axe longitudinal X de la carte, à l'extérieur vis-à-vis du levier d'extraction lorsque les deux leviers sont en position de verrouillage.

De cette manière, il n'est pas possible d'actionner le levier d'extraction avant d'avoir actionné l'organe de verrouillage.

Préférentiellement, l'organe de verrouillage est un levier mobile en rotation autour d'un axe latéral Y2, parallèle à l'axe latéral Y1 du levier d'extraction, décalé vis-à-vis de celui-ci vers l'extérieur du bâti et vers le haut, le levier de verrouillage comportant une extension latérale adaptée à venir se placer, selon l'axe longitudinal X, à l'extérieur du levier d'extraction du fait de la position relative des axes de rotations Y1 et Y2 lorsque le bâti portant une carté électronique est en position insérée et verrouillée, c'est-à-dire lorsque les deux leviers sont en position de verrouillage. Cette disposition permet d'empêcher une extraction d'une carte électronique par action de son levier d'extraction, tant que le levier de verrouillage n'a pas été préalablement actionné.

Selon un mode de réalisation préféré, l'extension latérale présente une surface interne, définie comme la face adaptée à faire face à la carte électronique en position de verrouillage de ladite carte, ladite surface interne comportant, en sa partie opposée à l'axe de rotation Y2, une butée perpendiculaire au plan moyen de ladite surface interne. Cette butée permet un blocage de l'extrémité du levier d'extraction dans une position intermédiaire entre sa position de repos et sa position de verrouillage.

Dans un mode de réalisation avantageux, la butée présente une hauteur voisine de l'épaisseur de l'extrémité du levier d'extraction. Cette dimension de butée permet de s'assurer que ladite butée bloque efficacement l'extrémité du levier d'extraction.

Préférentiellement, la distance *D2* entre l'axe Y2 et la butée est inférieure à la distance *D1* entre l'axe Y1 et l'extrémité du levier d'extraction. Cette disposition permet d'assurer que les trajectoires de l'extrémité du levier d'extraction et de la butée comportent un point d'intersection.

Plus particulièrement dans ce cas, *D1* vaut avantageusement environ 80% de D2.

Encore plus particulièrement, le cercle C1 décrit par l'extrémité du levier d'extraction, et le cercle C2, décrit par la butée du levier de verrouillage lors du mouvement dudit levier de verrouillage autour de son axe Y2, se coupent en un point d'intersection, correspondant à une position des leviers intermédiaire entre leur position de repos et leur position de verrouillage.

Dans un mode de réalisation particulier, le point d'intersection correspond à une position angulaire α0 du levier d'extraction comprise entre 30° et 50°, et à une position angulaire β0 du levier de verrouillage comprise entre 35° et 65°.

### Présentation des figures

Les caractéristiques et avantages de l'invention seront mieux appréciés grâce à la description qui suit, description qui expose les caractéristiques de l'invention au travers d'un exemple non limitatif d'application.

La description s'appuie sur les figures annexées dans lesquelles:
La figure 1, déjà citée, illustre, en vue en perspective, une carte électronique pour équipement embarqué, équipée de glissières de verrouillage,
La figure 2, également déjà citée, illustre une carte électronique montée dans un support à glissière, en vue de face,
La figure 3 montre, en vue en perspective, un groupe de trois cartes électroniques disposées au sein d'un cabinet électronique doté de supports glissières et de dispositif d'actionnement de glissières de verrouillage selon un mode de réalisation de l'invention,
La figure 4a montre, en vue de face, la disposition du levier de verrouillage vis-à-vis du levier d'extraction d'une carte électronique, dans une disposition conforme à l'invention,
La figure 4b est une vue en perspective du même levier pour glissière de verrouillage,
La figure 4c est une vue de dessus du même levier pour glissière de verrouillage,
La figure 5 illustre, en vue de côté, les cinématiques respectives du levier de verrouillage et du levier d'extraction,
Les figures 6a à 6h illustrent les positions du levier d'extraction et du levier de verrouillage, lors d'une phase d'insertion / verrouillage d'une carte électronique dans le cabinet électronique.

### Description détaillée d'un mode de réalisation de l'invention

L'invention trouve sa place dans le cadre d'équipement électroniques configurés sous forme de cabinets électroniques comportant un certain nombre de cartes électroniques 1. Dans le cas de l'invention, et tel qu'il a été présenté plus haut, ces cartes électroniques 1 sont insérées le long de supports glissières 3, de manière à permettre leur insertion ou leur extraction de façon aisée d'une carte fond de panier disposée dans le cabinet électronique.

La figure 3 illustre la disposition de trois cartes électroniques 1 dans une position de fonctionnement, lorsqu'elles sont engagées et verrouillées dans des logements du châssis 8 d'un cabinet électronique.

Chaque carte électronique 1 est ici solidarisée, comme il a été exposé plus haut, à un bâti 10 sensiblement rectangulaire, supportant des glissières de verrouillage 2a, 2b.

On définit pour la suite de la description un repère direct par rapport à ce bâti 10, ledit repère comportant
- un axe longitudinal X parallèle à la direction d'insertion de la carte 1 et du bâti dans le cabinet électronique, c'est-à-dire parallèle à un des bords du bâti 10 et de la carte électronique 1 (et perpendiculaire à la carte fond de panier qui les reçoit),
- un axe vertical Z perpendiculaire au précédent et situé dans un plan parallèle au plan moyen du bâti, c'est à dire parallèle à un second bord du bâti 10,
- un axe latéral Y perpendiculaire aux axes précédents.

Les termes d'avant, arrière, haut bas etc. sont définis par rapport à ce repère.

Dans le mode de réalisation décrit ici à titre non limitatif, chaque carte électronique 1 est insérée verticalement (plan XZ) dans un support glissière 3, et vient se connecter à une carte fond de panier par l'intermédiaire d'un connecteur 5. Les supports glissières 3 des diverses cartes électroniques 1 sont ménagés dans le plateau inférieur du châssis 8 du cabinet électronique. Ce plateau inférieur comporte en sa partie avant (à l'opposé de la carte fond de panier) une rainure 11 horizontale (parallèle à l'axe Y), s'étendant devant le bord avant des cartes électroniques 1 lorsque celles-ci sont insérées dans le cabinet électronique,

Chaque carte électronique 1 comporte, en au moins un de ses angles opposés à l'extrémité supportant le connecteur 5, un perçage 12 selon un axe Y1 parallèle à l'axe latéral Y.

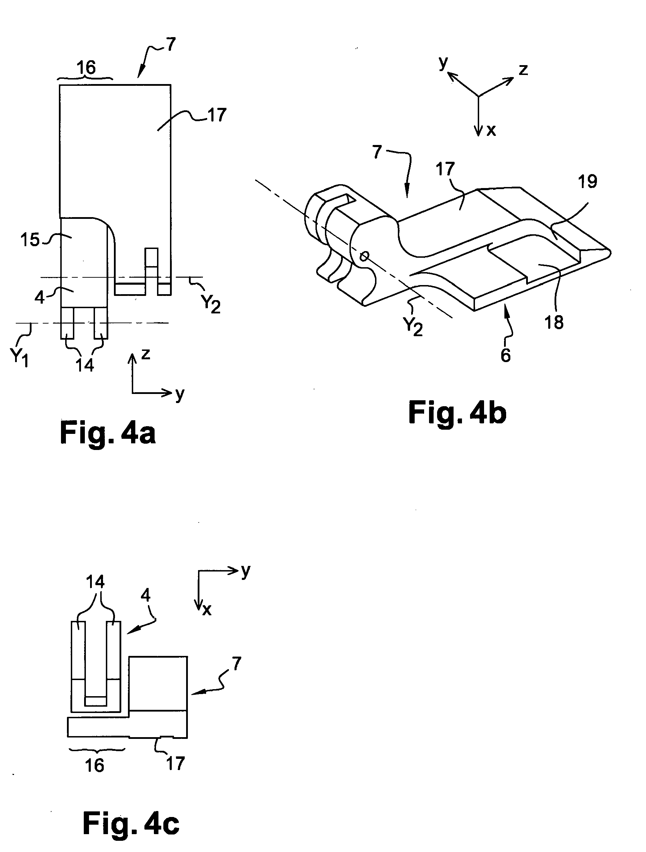

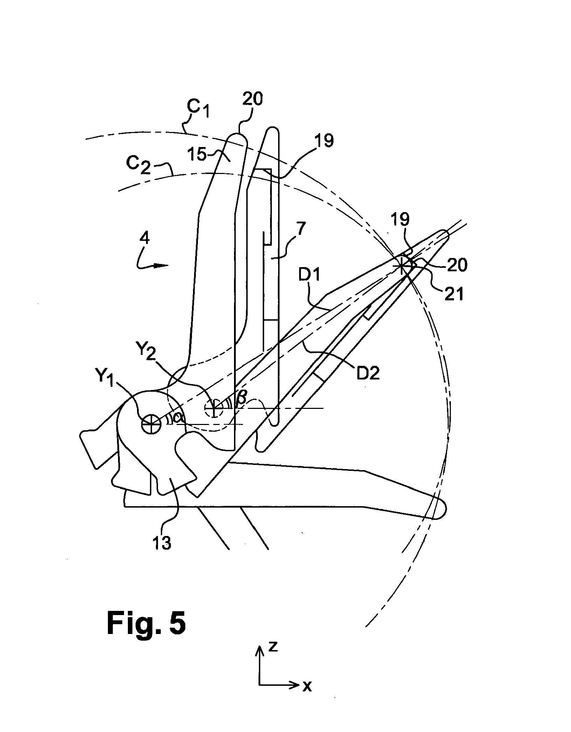

Un levier d'extraction 4, mobile autour de cet axe Y1, est installé sur chaque carte électronique 1. On voit sur la figure 4a que ce levier d'extraction 4, vu ici de face (selon l'axe X), comporte deux extensions 14 venant se placer de part et d'autre du perçage 12 lors de cette installation. De même, ce levier d'extraction 4, dont le profil est mieux visible figure 5, comporte un bras d'extraction 15, susceptible de prendre une position comprise angulairement entre une position parallèle au bord de la carte électronique 1, et une position sensiblement perpendiculaire à celle-ci. La trajectoire décrite par l'extrémité 20 dudit bras d'extraction 15 est un cercle C1 centré autour de l'axe Y1.

Ce levier d'extraction 4, de forme générale connue en soi, comporte, dans le présent exemple, une excroissance 13 venant prendre appui sur le bord intérieur de la rainure 11 lorsque la carte électronique 1 est insérée dans son logement. De même, l'excroissance 13, vient prendre appui sur le bord intérieur de la rainure 11 lorsqu'un effort visant à abaisser ledit levier d'extraction 4 lui est appliqué. De la sorte, un bras de levier significatif est créé entre la carte électronique 1 et la rainure 11 du châssis 8, ce qui assure la déconnexion de ladite carte électronique 1 vis-à-vis de la carte fond de panier.

Dans la disposition illustrée ici, comme dans l'art antérieur, une glissière de verrouillage 2 vient verrouiller chaque carte électronique 1 sur le support glissière 3 correspondant, par un serrage de ses mors mobiles (non illustrées figure 3) sur le même support glissière 3.

Ce serrage est obtenu par l'action d'un levier de verrouillage 7, qui vient serrer longitudinalement des mors enfilés sur une tige de traction, lesdits mors se déplaçant latéralement du fait de leur géométrie sous l'effet de la pression exercée entre eux, et venant ainsi appuyer sur les bords du support glissière 3.

Dans l'exemple de réalisation donné ici à titre non limitatif, le levier de verrouillage 7 est mobile autour d'un axe de rotation Y2, parallèle à l'axe de rotation Y1 du levier d'extraction 4, mais décalé vis-à-vis de celui-ci vers l'extérieur de la carte électronique 1 (axe X) et vers le haut (axe Z), c'est-à-dire plus près de son plan de symétrie horizontal de ladite carte électronique 1.

Cet axe de rotation Y2 est solidarisé à l'extrémité de la tige de traction (non illustrée sur les figures) de la glissière de verrouillage 2.

Comme on le voit sur la figure 4a, pour chaque carte électronique 1, le levier de verrouillage 7 prend place à côté du levier d'extraction 4.

Le levier de verrouillage 7 comporte un bras de verrouillage 17 susceptible de prendre une position comprise angulairement entre une position parallèle au bord de la carte électronique 1, et une position orientée vers le bas à 60° environ. La trajectoire décrite par l'extrémité dudit bras de verrouillage 17 est un cercle centré autour de l'axe Y2.

Le levier de verrouillage 7 comporte ici une extension latérale 16 (à la gauche du bras de verrouillage 17 sur la figure 4a) adaptée à venir se placer devant le levier d'extraction 4 (c'est-à-dire plus vers l'extérieur du cabinet électronique) du fait de la position relative des axes de rotations Y1 et Y2 lorsque la carte électronique 1 est en position insérée et verrouillée, c'est-à-dire lorsque les deux leviers sont en position de verrouillage.

Le bras d'extraction 15 est alors disposé entre la carte électronique 1 et l'extension latérale 16 du levier de verrouillage 7, lorsque la carte électronique 1 est insérée et verrouillée dans son logement.

Cette extension latérale 16 du levier de verrouillage 7 vient ainsi faire obstacle à la libre rotation dudit levier d'extraction 4. Cette extension latérale 16 se présente sous la forme d'une partie sensiblement plane, rectangulaire (voir figure 4b), s'étendant sensiblement sur toute la longueur du bras de verrouillage 17, c'est-à-dire sur toute la longueur du levier de verrouillage 7, hors zone de son articulation autour de l'axe Y2. La largeur de l'extension latérale 16 du levier de verrouillage 7 est légèrement supérieure à celle du bras d'extraction 15. De la sorte, une fois le levier de verrouillage 7 installé sur le bâti 10 des glissières de verrouillage, l'extension latérale 16 du levier de verrouillage 7 interfère avec le mouvement de rotation du levier d'extraction 4 autour de son axe Y1.

L'extension latérale 16 présente une continuité de surface externe (la surface externe étant définie comme celle qui est la plus distante de la carte électronique, en position de verrouillage de ladite carte) avec le bras de verrouillage 17, et présente une épaisseur inférieure à celle du bras de verrouillage 17, voisine de la moitié de celle-ci dans le présent exemple. De la sorte, la surface interne 18 de l'extension latérale 16 (la surface interne étant définie comme celle qui fait face à la carte électronique 1 en position de verrouillage de ladite carte), apparait en creux vis-à-vis de celle du bras de verrouillage 17.

Cette surface interne 18 comporte, en sa partie opposée à l'axe de rotation Y2, une butée 19 perpendiculaire au plan moyen de ladite surface interne 18. Cette butée décrit un cercle C2 lors du mouvement du levier de verrouillage 7 autour de son axe Y2 (voir figure 5). Cette butée 19 présente une hauteur voisine de l'épaisseur de l'extrémité 20 du bras d'extraction 15. La butée 19 est ici de forme plane, mais pourrait prendre toute autre forme adaptée à permettre le blocage de l'extrémité 20 du bras d'extraction 15.

La distance *D2* entre l'axe Y2 et la butée 19 est choisie inférieure à la distance *D1* entre l'axe Y1 et l'extrémité 20 du bras d'extraction 15. Dans le présent exemple de réalisation, *D1* vaut environ 80% de *D2.*

De cette manière, du fait de la disposition relative des deux axes de rotation Y1 (du levier d'extraction4) et Y2 (du levier de verrouillage 7), le cercle C1 décrit par l'extrémité 20 du bras d'extraction 15 et le cercle C2 décrit par la butée 19 du levier de verrouillage 7 se coupent notamment en un point 21. Ce point 21 correspond à une position angulaire α0 du levier d'extraction 4 et une position angulaire β0 du levier de verrouillage 7.

Dans le présent exemple de réalisation, l'angle α0 vaut environ 40° et l'angle β0 environ 45°.

### Mode de fonctionnement

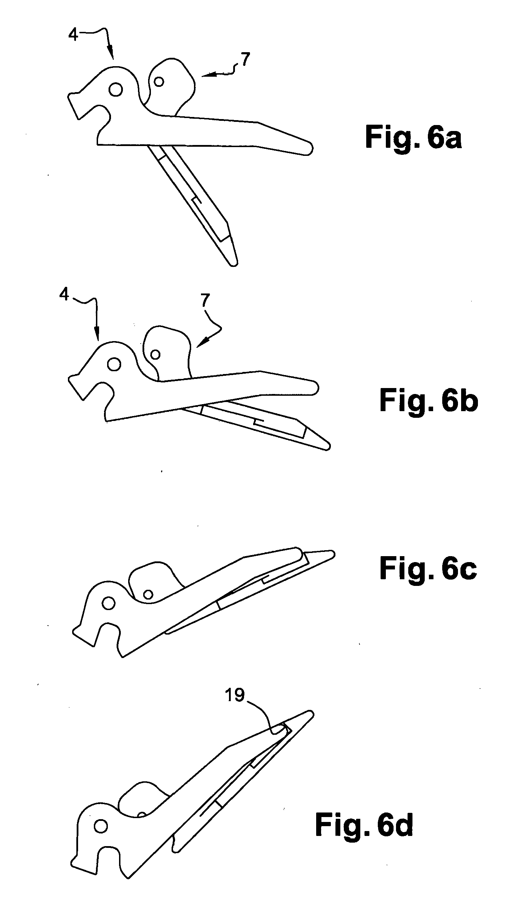

En fonctionnement, comme on le voit sur les figures 6a à 6h, et partant d'une position (figure 6a) dans laquelle la carte électronique 1 est extraite, glissières 2a, 2b déverrouillées, correspondant à une position sensiblement horizontale du levier d'extraction 4 (α = 0°) et une position baissée du levier de verrouillage 7 (β = 45°), on suppose qu'un utilisateur pousse le levier de verrouillage 7 vers le haut (angle β augmentant) pour insérer et verrouiller simultanément la carte électronique 1 dans on logement.

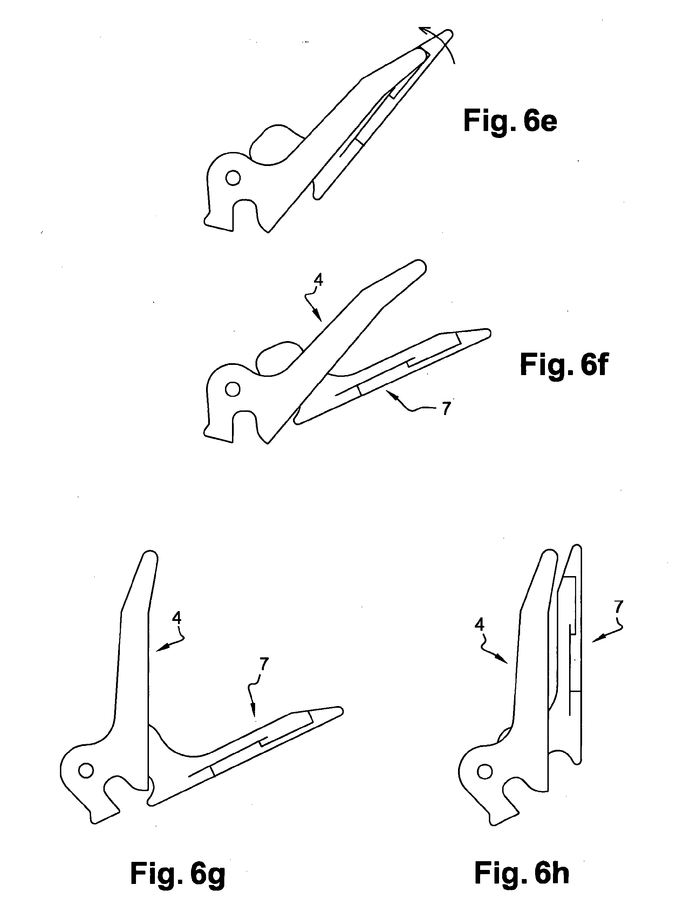

On voit sur la figure 6b que le mouvement de rotation du levier de verrouillage 7 amène le bord inférieur interne 21 de l'extension latérale 16 de celui-ci à venir en contact avec la face externe du levier d'extraction 4. Ceci provoque un mouvement de rotation simultané des deux leviers (figures 6c à 6e). Dans la position de la figure 6e, correspondant à α = α0 et β = β0, l'extrémité 20 du bras d'extraction 15 vient se bloquer contre la butée 19 de l'extension latérale 16 du levier de verrouillage 7. Il est alors impossible de poursuivre le mouvement conjoint des deux leviers. Il est nécessaire (figure 6f) d'abaisser le levier de verrouillage 7, pour poursuivre l'insertion de la carte par l'action du levier d'extraction 4 (figure 6g). Puis le levier de verrouillage 7 est amené en position de verrouillage (figure 6h).

### Avantages

Par l'utilisation du dispositif décrit, il devient impossible de tenter d'extraire la carte avant qu'elle ait été déverrouillée. De même, il devient impossible de tenter d'opérer simultanément l'insertion de la carte dans son connecteur et le verrouillage des glissières. Le dispositif rend obligatoire le respect d'une séquence de ces opérations, comprenant d'abord l'insertion, puis le verrouillage, ou, en sens inverse, d'abord le déverrouillage puis l'extraction.

## Revendications

1. Dispositif de verrouillage / déverrouillage de carte électronique (1), ladite carte électronique (1) étant du type adaptée à être insérée dans un cabinet électronique, en suivant au moins un support glissière (3), ménagé dans le châssis (8) dudit cabinet électronique, le dispositif comportant :
- un bâti (10) sensiblement rectangulaire, adapté à être solidarisé à la carte électronique (1), le bâti (10) supportant au moins une glissière de verrouillage (2), adaptée à verrouiller la carte électronique (1) sur le support glissière (3), par l'action d'un levier de verrouillage (7), lors de l'insertion de la carte dans le châssis (8),
un repère direct étant défini par rapport à ce bâti, ledit repère comportant un axe longitudinal X parallèle à la direction d'insertion du bâti (10) dans le cabinet électronique, un axe vertical Z perpendiculaire au précédent et situé dans un plan parallèle au plan moyen du bâti, et un axe latéral Y perpendiculaire aux axes précédents,
- un levier d'extraction (4), mobile en rotation, entre une position de repos et une position de verrouillage, autour d'un axe Y1, parallèle à l'axe Y, ledit levier d'extraction (4) étant adapté à permettre l'application d'un effort selon l'axe longitudinal X entre la carte électronique (1) ou le bâti (10) et le châssis,
le dispositif étant **caractérisé en ce que** le levier de verrouillage (7) est mobile en rotation autour d'un axe latéral Y2, parallèle à l'axe latéral Y1 du levier d'extraction (4),
entre une position dite de repos et une position dite de verrouillage, le dit levier de verrouillage (7) comportant une extension (16) pourvu d'une butée (19) pour le blocage de l'extrémité (20) du levier d'extraction (4) dans une position intermédiaire entre sa position de repos et sa position de verrouillage.

2. Dispositif selon la revendication 1, **caractérisé en ce que** l'axe latéral Y2, parallèle à l'axe latéral Y1 du levier d'extraction (4), est décalé vis-à-vis de celui-ci vers l'extérieur du bâti (10) et vers le haut, l'extension latérale (16) du levier de verrouillage (7) étant adaptée à venir se placer, selon l'axe longitudinal X, à l'extérieur du levier d'extraction (4) du fait de la position relative des axes de rotations Y1 et Y2 lorsque le bâti (10) portant une carté électronique (1) est en position insérée et verrouillée, c'est-à-dire lorsque les deux leviers (4, 7) sont en position de verrouillage.

3. Dispositif selon la revendication 2, **caractérisé en ce que** l'extension latérale (16) présente une surface interne (18), définie comme la face adaptée à faire face à la carte électronique (1) en position de verrouillage de ladite carte, ladite surface interne comportant, en sa partie opposée à l'axe de rotation Y2, une butée (19) perpendiculaire au plan moyen de ladite surface interne (18).

4. Dispositif selon l'une quelconque des revendications 2 ou 3, **caractérisé en ce que** la butée (19) présente une hauteur voisine de l'épaisseur de l'extrémité (20) du levier d'extraction (4).

5. Dispositif selon l'une quelconque des revendications 2 à 4, **caractérisé en ce que** la distance *D2* entre l'axe Y2 et la butée (19) est choisie inférieure à la distance *D1* entre l'axe Y1 et l'extrémité (20) du levier d'extraction (4).

6. Dispositif selon la revendication 5, **caractérisé en ce que** *D1* vaut environ 80% de *D2.*

7. Dispositif selon l'une quelconque des revendications 2 à 6, **caractérisé en ce que** le cercle C1 décrit par l'extrémité (20) du levier d'extraction (4), et le cercle C2, décrit par la butée (19) du levier de verrouillage (7) lors du mouvement dudit levier de verrouillage (7) autour de son axe Y2, se coupent en un point d'intersection (21), correspondant à une position des leviers intermédiaire entre leur position de repos et leur position de verrouillage.

8. Dispositif selon la revendication 7, **caractérisé en ce que** le point d'intersection (21) correspond à une position angulaire α0 du levier d'extraction (4) comprise entre 30° et 50°, et à une position angulaire β0 du levier de verrouillage (7) comprise entre 35° et 65°.

## Patentansprüche

1. Vorrichtung zur Verriegelung/Entriegelung einer Elektronikkarte (1), wobei die Elektronikkarte (1) von der Art ist, die geeignet ist, um in ein Elektronikgehäuse eingesteckt zu werden, indem sie mindestens einem Gleitführungsträger (3) folgt, der im Gestell (8) des Elektronikgehäuses ausgebildet ist, wobei die Vorrichtung aufweist:
- einen im Wesentlichen rechtwinkligen Rahmen (10), der geeignet ist, um fest mit der Elektronikkarte (1) verbunden zu werden, wobei der Rahmen (10) mindesten s **eine** Verriegelungsschiene (2) trägt, die geeignet ist, um die Elektronikkarte (1) durch die Wirkung eines Verriegelungshebels (7) beim Einstecken der Karte in das Gestell (8) auf dem Gleitführungsträger (3) zu verriegeln,
wobei ein direktes Bezugssystem bezüglich dieses Rahmens definiert ist, wobei das Bezugssystem eine Längsachse X parallel zur Einsteckrichtung des Rahmens (10) in das Elektronikgehäuse, eine senkrechte Achse Z lotrecht zur vorhergehenden und in einer parallel zur Mittelebene des Rahmens befindlichen Ebene und eine seitliche Achse Y lotrecht zu den vorhergehenden Achsen aufweist,
- einen Entnahmehebel (4), der zwischen einer Ruhestellung und einer Verriegelungsstellung um eine Achse Y1 parallel zur Achse Y drehbeweglich ist, wobei der Entnahmehebel (4) geeignet ist, um die Anwendung einer Kraft gemäß der Längsachse X zwischen der Elektronikkarte (1) oder dem Rahmen (10) und dem Gestell zu erlauben,
wobei die Vorrichtung **dadurch gekennzeichnet ist, dass** der Verriegelungshebel (7) um eine seitliche Achse Y2 parallel zur seitlichen Achse Y1 des Entnahmehebels (4) zwischen einer so genannten Ruhestellung und einer Verriegelungsstellung drehbeweglich ist, wobei der Verriegelungshebel (7) eine Verlängerung (16) aufweist, die mit einem Anschlag (19) zur Blockierung des Endes (20) des Entnahmehebels (4) in einer Zwischenstellung zwischen seiner Ruhestellung und seiner Verriegelungsstellung versehen ist.

2. Vorrichtung nach Anspruch 1, **dadurch gekennzeichnet, dass** die seitliche Achse Y2 parallel zur seitlichen Achse Y1 des Entnahmehebels (4) gegenüber dieser nach außerhalb des Rahmens (10) und nach oben versetzt ist, wobei die seitliche Verlängerung (16) des Verriegelungshebels (7) geeignet ist, um sich aufgrund der relativen Stellung der Drehachsen Y1 und Y2 gemäß der Längsachse X außerhalb des Entnahmehebels (4) zu positionieren, wenn der eine Elektronikkarte (1) tragende Rahmen (10) in der eingesteckten und verriegelten Stellung ist, d.h., wenn die zwei Hebel (4, 7) in der Verriegelungsstellung sind.

3. Vorrichtung nach Anspruch 2, **dadurch gekennzeichnet, dass** die seitliche Verlängerung (16) eine Innenfläche (18) aufweist, die als die Seite definiert wird, die geeignet ist, der Elektronikkarte (1) in der Verriegelungsstellung der Karte gegenüber zu liegen, wobei die Innenfläche in ihrem der Drehachse Y2 entgegengesetzten Teil einen Anschlag (19) lotrecht zur Mittelebene der Innenfläche (18) aufweist.

4. Vorrichtung nach einem der Ansprüche 2 oder 3, **dadurch gekennzeichnet, dass** der Anschlag (19) eine Höhe nahe der Dicke des Endes (20) des Entnahmehebels (4) aufweist.

5. Vorrichtung nach einem der Ansprüche 2 bis 4, **dadurch gekennzeichnet, dass** der Abstand D2 zwischen der Achse Y2 und dem Anschlag (19) geringer als der Abstand D1 zwischen der Achse Y1 und dem Ende (20) des Entnahmehebels (4) gewählt wird.

6. Vorrichtung nach Anspruch 5, **dadurch gekennzeichnet, dass** D1 etwa 80% von D2 beträgt.

7. Vorrichtung nach einem der Ansprüche 2 bis 6, **dadurch gekennzeichnet, dass** der vom Ende (20) des Entnahmehebels (4) beschriebene Kreis C1 und der vom Anschlag (19) des Verriegelungshebels (7) bei der Bewegung des Verriegelungshebels (7) um seine Achse Y2 beschriebene Kreis C2 sich in einem Schnittpunkt (21) schneiden, der einer Zwischenstellung der Hebel zwischen ihrer Ruhestellung und ihrer Verriegelungsstellung entspricht.

8. Vorrichtung nach Anspruch 7, **dadurch gekennzeichnet, dass** der Schnittpunkt (21) einer Winkelstellung α0 des Entnahmehebels (4) zwischen 30° und 50° und einer Winkelstellung β0 des Verriegelungshebels (7) zwischen 35° und 65° entspricht.

## Claims

1. Device for locking/unlocking an electronic card (1), said electronic card (1) being of the type adapted to be inserted in an electronic cabinet by sliding it along at least one support (3) arranged in the chassis (8) of said electronic cabinet, the device comprising:
- a substantially rectangular frame (10) adapted to be secured to the electronic card (1), the frame (10) supporting at least one locking slide (2) adapted to lock the electronic card (1) on the sliding support (3) by the action of a locking lever (7), a direct marker being defined relative to this frame, said marker having a longitudinal axis X parallel to the direction of insertion of the frame (10) into the electronic cabinet, a vertical axis Z perpendicular to the former and situated in a plane parallel to the mean plane of the frame, and a lateral axis Y perpendicular to the previous axes, and
- an extraction lever (4) mobile in rotation between a rest position and a locking position about an axis Y1 parallel to the axis Y, said extraction lever (4) being adapted to allow the application of a force along the longitudinal axis X between the electronic card (1) or the frame (10) and the chassis, the device being **characterized in that** said locking lever (7) is rotatable about a lateral axis Y2 parallel to the lateral axis Y1 of the extraction lever (4) between a rest position and a locking position, said locking lever (7) having an extension (16) provided with a stop (19) for locking the end (20) of the extraction lever ( 4 ) in an intermediate position between its rest position and its locking position.

2. Device according to claim 1, **characterized in that** the lateral axis Y2 parallel to the lateral axis Y1 of the extraction lever (4) is offset relative to the latter toward the outside of the frame (10) and upwardly, the lateral extension (16) of the locking lever (7) being adapted to be placed along the longitudinal axis X outside the extraction lever (4) because of the relative position of the rotation axes Y1 and Y2 when the frame (10) carrying an electronic card (1) is in the inserted and locked position, that is to say when the two levers (4, 7) are in the locking position.

3. Device according to claim 2, **characterized in that** the lateral extension (16) has an inner surface (18) defined as the face adapted to face the electronic card (1) in the locking position of said card, said inner surface having in its part opposite the rotation axis Y2 a stop (19) perpendicular to the mean plane of said inner surface (18).

4. Device according to either of claims 2 or 3, **characterized in that** the stop (19) has a height similar to the thickness of the end (20) of the extraction lever (4).

5. Device according to any one of claims 2 to 4, **characterized in that** the distance D2 between the axis Y2 and the stop (19) is less than the distance *D1* between the axis Y1 and the end (20) of the extraction lever (4).

6. Device according to claim 5, **characterized in that** *D1* is about 80% of *D2.*

7. Device according to any one of claims 2 to 6, **characterized in that** the circle C1 described by the end (20) of the extraction lever (4) and the circle C2 described by the stop (19) of the locking lever (7) upon movement of said locking lever (7) about its axis Y2 intersect at an intersection point (21) corresponding to a position of the intermediate levers between their rest position and their locking position.

8. Device according to claim 7, **characterized in that** the intersection point (21) corresponds to an angular position α0 of the extraction lever (4) between 30° and 50° and an angular position β0 of the locking lever (7) between 35° and 65°.
